# EUROPEAN PATENT SPECIFICATION

(11) **EP 1 608 793 B1**
(45) Date of publication and mention of the grant of the patent: **12.05.2010**
(21) Application number: 04723248.3
(22) Date of filing: 25.03.2004
(51) Int. Cl.: C23C 16/40, C03C 17/245

(54) **TITANIA COATINGS**
TITANDIOXID-BESCHICHTUNGEN
REVETEMENTS EN OXYDE DE TITANE

(30) Priority: 25.03.2003 GB 0306797
(43) Date of publication of application: 28.12.2005
(73) Proprietor: Pilkington Group Limited, St. Helens Merseyside WA10 3TT (GB)
(72) Inventor: YE, Liang, Merseyside PR9 7DU (GB)
(74) Representative: Hazzard, Alan David
(86) International application number: PCT/GB2004/001310
(87) International publication number: WO 2004/085701

(56) References cited:
- WO-A-00/75087
- WO-A-98/41480
- US-A- 3 463 658
- US-A1- 2002 166 507
- US-A1- 2003 039 843
- PATENT ABSTRACTS OF JAPAN vol. 0041, no. 40 (C-026), 3 October 1980 (1980-10-03) & JP 55 090441 A (ASAHI GLASS CO LTD), 9 July 1980 (1980-07-09)

## Description

This invention relates to substrates having a titania coating on at least one surface and to processes for depositing titania coatings upon the surface of a substrate. In the preferred embodiments the substrate is a glass sheet.

Titania coatings are known to possess photocatalytic self cleaning properties. Titania coated substrates and processes for the production of such coated substrates have been described for example in EPA 901991, WO 97/07069, WO 97/10186, WO 98/41480 and WO 00/75087. The coatings may be deposited by a variety of techniques including sol-gel processes, spray pyrolysis processes, magnetron sputtered vacuum deposition processes and chemical vapour deposition processes.

We have now discovered novel chemical vapour deposition processes (hereinafter for convenience CVD processes) which lead to the production of coated substrates having improved properties. In a preferred embodiment these CVD processes may be integrated with a float glass production process to produce a novel coated glass sheet in an efficient economic manner. These processes comprise bringing a vapour comprising a titanium precursor into contact with the hot glass ribbon at a point in the process where the temperature of the ribbon is sufficient to result in the formation of the desired titania coating.

A variety of titanium precursors have been proposed for use in CVD processes for the deposition of titania. Examples include inorganic compounds such as titanium tetrachloride and organic titanium compounds such as titanium tetra isopropoxide and titanium tetraethoxide. Those precursors which do not contain oxygen as part of their molecular structure are normally used in the presence of oxygen or an oxygen containing compound. WO 00/75087 discloses a CVD process which uses titanium tetrachloride together with ethyl acetate. Those precursors which do contain oxygen as part of their molecular structure may be used with or without an additional source of oxygen. WO 00/75087 discloses a CVD process which uses titanium tetraethoxide in the absence of any additional source of oxygen. EPA 901991 discloses a CVD process which uses titanium tetra isopropoxide and titanium tetraethoxide in combination with oxygen gas. US 2003/039843A1 discloses a method of forming a photoactive coating using a precursor composition which includes a titania precursor material and at least one precursor material having at least one photoactivity enhancing material. JP 55090441A discloses a process for the production of a titanium oxide film on a glass substrate using, in which the glass substrate is pulled out from a melting furnace and heated to about 500-650°C and is contacted with an organic titanium alkoxide precursor. US 3,463,658 discloses a process for coating glass containers with tin oxide and/or titanium oxide.

There is an ongoing need for a process which deposits a titania coating of the desired quality in a cost effective manner.

We have now discovered that a CVD process for the deposition of a titanium oxide coating which uses a vapour comprising an organo titanium compound and an oxygen containing organic compound is more efficient than known processes and may produce a titania coating which exhibits improved properties. The coatings may be smoother, may be more durable and may be less susceptible to deactivation when deposited directly onto a glass surface.

Accordingly this invention provides a chemical vapour deposition process for the deposition of a photocatalytically active coating comprising a titanium oxide on the surface of a glass ribbon according to claim 1.

The organic titanium compound is titanium tetra isopropoxide or titanium tetra ethoxide.

The preferred esters are compounds having the formula

R-C(O)-O- C(XX¹) - C(YY¹) - R¹

wherein R and R¹ which may be the same or different represent hydrogen atoms or an alkyl group comprising from 1 to 10 carbon atoms; X, X¹, Y and Y¹ which may be the same or different represent hydrogen atoms or alkyl groups comprising from 1 to 4 carbon atoms with the proviso that at least one of Y or Y¹ represents a hydrogen atom. Preferably R and R¹ represent hydrogen atoms or alkyl groups containing from 1 to 4 carbon atoms.

Examples of esters which are preferred for use in the processes of this invention include ethyl formate, ethyl acetate, ethyl propionate, ethyl butyrate, n-propyl formate, n-propyl acetate, n-propyl propionate, n propyl butyrate, isopropyl formate, isopropyl acetate, isopropyl propionate, isopropyl butyrate, n-butyl formate, n-butyl acetate, sec butyl acetate and t butyl acetate.

The most preferred esters for use in this invention are ethyl formate, ethyl propionate and in particular ethyl acetate.

A mixture of two or more carboxylate esters may be used. The fluid mixture may also comprise a minor proportion of gaseous oxygen. The introduction of larger proportions of oxygen into the fluid mixture is less preferred and may result in the deposition of coatings having inferior properties. The fluid mixture will normally further comprise an inert carrier gas in which the active components are entrained. The most commonly the carrier gases are nitrogen and helium. The organic titanium compound and the ester will generally comprise form 0.1 to 1.0% by volume of the fluid mixture. The molar ratio of the oxygen containing organic compound to the organic titanium compound will preferably be in the range 0.5:1.0 to 1.2:1.0, more preferably in the range 0.8:1.0 to 1.0:1.0.

The substrate is a ribbon of glass produced by a float glass process. The deposition is carried out on-line during a float glass production process.

The fluid mixture should be contacted with the substrate at an elevated temperature. Generally the substrate should be heated to a temperature in the range 400 to 800°C. The temperature of the glass ribbon in a float glass production process ranges from around 1100°C at the hot end of the float bath to 600°C at the cold end and from about 580°C to 200°C in the annealing lehr. The processes of this invention may be carried out at a suitable point in the float bath, in the gap between the float bath and the annealing lehr or in the hotter end of the annealing lehr. The processes of this invention are preferably carried out by bringing the fluid mixture into contact with the substrate when that substrate is at a temperature of from 610° C to 720° C, preferably in the range 625° C to 700° C and more preferably in the range 625°C to 650°C. Where these preferred processes are carried out as part of a float glass production process they will be carried out at a point which lies within the float bath.

The rate of flow of the fluid mixture should be adjusted so as to provide the desired coating. The optimum rate is affected by a variety of factors including the nature and temperature of the substrate, the surface area of the substrate, the line speed of the glass ribbon in a float glass production process and the rate at which exhaust gas is removed from the coating apparatus.

The titania coating may be deposited on the surface of the glass itself or one or more undercoatings may be deposited onto the glass prior to the deposition of the titania layer. In a preferred embodiment of this invention the titania coating is deposited directly onto the surface of a glass ribbon during a float glass production process. Deposition directly on the glass surface can lead to enhanced growth of titania compared to deposition upon an undercoat.

A multilayer coating may conveniently be applied by arranging two or more coating apparatus in sequence along the glass ribbon. One particular type of undercoat which is known to be advantageous is an alkali metal blocking layer. It is known, that migration of sodium ions was from an uncoated glass substrate into a photocatalytic titania layer deposited on that substrate may reduce the photocatalytic activity. The use of sodium ion blocking layers has been disclosed for example in WO 98/41480 and in WO 00/75087. Another type of undercoating uses an alkali metal blocking layer over a metal oxide coating such as tin oxide to create a colour suppression effect.

The alkali metal blocking underlayer may comprise a metal oxide but preferably the alkali metal blocking layer is a layer of a silicon oxide. The silicon oxide may be silica i.e. may have the stoichiometry SiO₂ or may comprise other elements such as carbon (such layers commonly being referred to as silicon oxycarbide and deposited e.g. as described in GB 2199848) or nitrogen (such layers commonly being referred to as silicon oxynitride).

The alkali metal blocking undercoat should be sufficiently thick as to reduce or block the migration of alkali metal ions into the titania layer to the desired degree. The layer should also preferably have no significant effect upon the optical properties of the glass. Thinner layers exert a smaller effect and as a result the thickness of the undercoat may be selected so as to provide a compromise between these two preferred objectives. Typically the undercoat (when present) will have a thickness of from 30 to 70 nm more preferably from 40 to 60 nm.

The titania coatings which are produced by the processes of this invention comprise a dense titanium dioxide layer which prevents sodium migration from reducing photoactivity. The thickness of the coating which is required in order to avoid sodium ions migrating from the glass to the surface of the coating and thereby reducing the photocatalytic activity of the coating may be reduced or preferably eliminated. Where a sodium ion blocking undercoat is present the thickness of that blocking layer may also be reduced compared to that used under titania coatings deposited by other CVD processes. Where the titania coatings is deposited directly onto the surface of the glass the thickness of that coating is preferably in the range 10nm to 40nm, preferably in the range 15nm to 35nm and most preferably in the range 10nm to 20nm. Where the titania coating is deposited on top of an alkali metal blocking undercoat the thickness of the titania coating is preferably in the range 10nm to 20nm.

The glass substrate will normally be a clear soda-lime float glass. The glass substrate may also be a tinted glass i.e. a glass to which a colourant such as iron oxide, cobalt oxide, nickel oxide, selenium oxide or titanium oxide has been added. Such tinted glasses are readily available in a variety of shades such as grey, bronze, blue and green.

The processes of this invention are advantageous in so far as they deposit the titania coating more consistently than previously known processes. They may be operated for extended periods without any deterioration in product quality and this improves the economics of the process. Further the coating exhibits a more neutral colour as measured by the CIELAB Colour System (Illuminant C). Analysis shows that the coating contains a smaller amount of carbon atoms than has previously been found and this appears to produce the more neutral colouring. Coatings comprising less than 10% of carbon form a preferred aspect of this invention.

The coated substrates may exhibit novel and useful properties. In particular the titania coating may consist substantially or essentially of crystalline titania which coating has a smoothness which is comparable to that of amorphous titania. Such ' products are advantageous in that they exhibit the high degree of photocatalytic activity which is associated with crystalline titania whilst the smoothness of the surface reduces the tendency of dirt or other contaminants to stick to the surface and enables any dirt adhering to the surface to be washed away more easily.

The preferred coated substrates have a titania coating on at least one surface thereof which coating is crystalline and has a roughness value Ra of less than 3.0 nm, more preferably less than 1.5nm and most preferably less than 1 nm. Such substrates are believed to be novel and comprise a further aspect of the invention.

The coatings are further characterised in that the average grain plain view diameter (which may be measured using high resolution SEM) is less than 20 nm, preferably less than 15nm and most preferably less than 10 nm.. These small grain sizes appear to be associated with a columnar grain structure and in the preferred coatings of this invention the titania grains will have a diameter to height ratio (which may be determined using XTEM) of less than 0.6 and preferably less than 0.4. The coatings have a relatively uniform particle size which can be appreciated by visual inspection of the SEM.

This invention allows thinner titania coatings to be produced having a lower reflection, preferably 12% or less, whilst retaining the photoactivity and durability. Applicants associate these improved properties with the dense and small grain structure of the coatings.

Photocatalytic activity for the purposes of this specification is determined by measuring the percentage reduction of the integrated absorption peaks corresponding to the C-H stretches of a thin film of stearic acid which is produced by illumination by UV light from a UVA lamp having an intensity of about 0.76 w/m²/nm at the surface of the substrate and a peak wavelength of 340nm for a period of 30 minutes. The stearic acid film may be formed by spin casting a solution of stearic acid in methanol on the surface of the substrate.

Freshly prepared or cleaned glass has a hydrophilic surface (a static water contact angle of lower than about 40° indicates a hydrophilic surface), but organic contaminants rapidly adhere to the surface increasing the contact angle. A particular benefit of coated substrates (and especially coated glasses) of the present invention is that they have a smaller contact angle when produced but more importantly when the coated surface is soiled with organic contaminents irradiation of the coated surface by UV light of the right wavelength will reduce the contact angle by reducing or destroying those contaminants. A further advantage is that water will spread out over the low contact angle surface reducing the distracting effect of droplets of water on the surface (e.g. from rain) and tending to wash away any grime or other contaminants that have not been destroyed by the photocatalytic activity of the surface. The static water contact angle is the angle subtended by the meniscus of a water droplet on a glass surface and may be determined in a known manner by measuring the diameter of a water droplet of known volume on a glass surface and calculated using an iterative procedure.

Preferably, the coated substrate has a haze of no more than 1% and prefereably no more than 0.5 or even 0.2% which is beneficial because this allows clarity of view through a transparent coated substrate.

In preferred embodiments, the coated surface of the substrate is more durable than existing titania coated self cleaning glasses. Preferably the coated surface remains photocatalytically active after it has been subjected to 500 strokes of the European standard abrasion test, and more preferably the coated surface remains photocatalytically active after it has been subjected to 1000 strokes of the European standard abrasion test.

This is advantageous because self cleaning coated substrates will often be used with the coated surface exposed to the outside (e.g. coated glasses with the coated surface of the glass as the outer surface of a window) where the coating is vulnerable to abrasion.

The European standard abrasion test refers to the abrasion test described in European standard BS EN 1096 Part 2 (1999) and comprises the reciprocation of a felt pad at a set speed and pressure over the surface of the sample.

In the present specification, a coated substrate is considered to remain photocatalytically active if, after being subjected to the European abrasion test, irradiation by UV light (e.g. of peak wavelength 351 nm) reduces the static water contact angle to below 15°. To achieve this contact angle after abrasion of the coated substrate will usually take less than 48 hours of irradiation at an intensity of about 0.76 W/m²/nm at the surface of the coated substrate.

Preferably, the haze of the coated substrate is 2% or lower after being subjected to the European standard abrasion test.

Durable coated substrates are also durable to humidity cycling (which is intended to have a similar effect to weathering). Thus, in preferred embodiments of the invention, the coated surface of the substrate is durable to humidity cycling such that the coated surface remains photocatalytically active after the coated substrate has been subjected to 200 cycles of the humidity cycling test. In the present specification, the humidity cycling test refers to a test wherein the coating is subjected to a temperature cycle of 35°C to 75°C to 35°C in 6 hours at near 100% relative humidity. The coated substrate is considered to remain photocatalytically active, if, after the test, irradiation by UV light reduces the static water contact angle to below 15°.

The durability of the coatings may also be assessed by means of a sodium hydroxide etching test. A sample of the coated glass is immersed in a 1M solution of sodium hydroxide which is maintained at a temperature of 75°C. The test is terminated at the point when the coating can be wiped from the surface of the glass or when the optical properties of the glass are significantly impaired. Glasses coated according to the processes of this invention are unaffected after six hours immersion and in the preferred embodiments are unaffected after ten hours immersion.

The coating also exhibits improved scratch resistance. Photoactive coatings are necessarily on amn exposed face of the glass and scratching during processing or after installation leaves a cosmetically unacceptable mark on the glass. Scratch resistance is measured using a pin on disc test using a variable load on the pin. Scratch resistance is measured as the minimum load which results in a continuous scratch on the surface. The coatings of this invention are not scratched by a load of 3 Nm and in the preferred embodiments are not scratched by loads of 5 Nm or even 10 Nm Coated substrates have uses in many areas, for example as glazings in windows including in a multiple glazing unit comprising a first glazing pane of a coated substrate in spaced opposed relationship to a second glazing pane, or, when the coated substrate is coated glass, as laminated glass comprising a first glass ply of the coated glass, a polymer interlayer (of, for example, polyvinylbutyral) and a second glass ply.

In addition to uses in self-cleaning substrates (especially self-cleaning glass for windows), coated substrates may also be useful in reducing the concentration of atmospheric contaminants. For example, coated glass under irradiation by light of UV wavelengths (including UV wavelengths present in sunlight) may destroy atmospheric contaminants for example, nitrogen oxides, ozone and organic pollutants, adsorbed on the coated surface of the glass. This use is particularly advantageous in the open in built-up areas (for example, in city streets) where the concentration of organic contaminants may be relatively high (especially in intense sunlight), but where the available surface area of glass is also relatively high. Alternatively, the coated glass (with the coated surface on the inside) may be used to reduce the concentration of atmospheric contaminants inside buildings, especially in office buildings having a relatively high concentration of atmospheric contaminants.

The invention is illustrated but not limited by the following drawings.

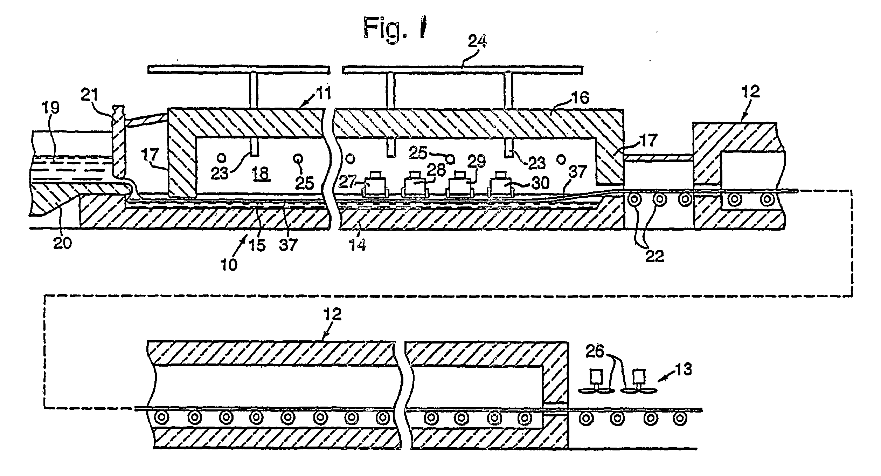

Figure 1 illustrates an apparatus for on line chemical vapour deposition of coatings according to the invention.

The layers of the coating may be applied on line onto the glass substrate by chemical vapour deposition during the glass manufacturing process. FIG. 1 illustrates an apparatus, indicated generally at 10, useful for the on line production of the coated glass article of the present invention, comprising a float section 11, a lehr 12, and a cooling section 13. The float section 11 has a bottom 14 which contains a molten tin bath 15, a roof 16, sidewalls (not shown), and end walls 17, which together form a seal such that there is provided an enclosed zone 18, wherein a non-oxidising atmosphere is maintained to prevent oxidation of the tin bath 15. During operation of the apparatus 10, molten glass 19 is cast onto a hearth 20, and flows therefrom under a metering wall 21, then downwardly onto the surface of the tin bath 15, forming a float glass ribbon 37, which is removed by lift-out rolls 22 and conveyed through the lehr 12, and thereafter through the cooling section 13.

A non-oxidising atmosphere is maintained in the float section 11 by introducing a suitable gas, such as for example one comprising nitrogen and 2% by volume hydrogen, into the zone 18, through conduits 23 which are operably connected to a manifold 24. The non-oxidising gas is introduced into the zone 18 from the conduits 23 at a rate sufficient to compensate for losses of the gas (some of the non-oxidising atmosphere leaves the zone 18 by flowing under the end walls 17), and to maintain a slight positive pressure above ambient pressure. The tin bath 15 and the enclosed zone 18 are heated by radiant heat directed downwardly from heaters 25. The heat zone 18 is generally maintained at a temperature of about 1330°F to 1400°F (721°C to 760°C). The atmosphere in the lehr 12 is typically air, and the cooling section 13 is not enclosed. Ambient air is blown onto the glass by fans 26.

The apparatus 10 also includes coaters 27, 28, 29 and 30 located in series in the float zone 11 above the float glass ribbon 37. The precursor gaseous mixtures for the individual layers of the coating are supplied to the respective coaters, which in turn direct the precursor gaseous mixtures to the hot surface of the float glass ribbon 37. The temperature of the float glass ribbon 37 is highest at the location of the coater 27 nearest the hearth 20 and lowest at the location of the coater 30 nearest the lehr 12.

The invention is further illustrated by the following Examples, in which coatings were applied by laminar flow chemical vapour deposition in the float bath on to a moving ribbon of float glass during the glass production process. In the Examples either one or two layer coatings were applied to the glass ribbon.

All gas volumes are measured at standard temperature and pressure unless otherwise stated. The thickness values quoted for the layers were determined using high resolution scanning electron microscopy and optical modelling of the reflection and transmission spectra of the coated glass. Thickness of the coatings was measured with an uncertainty of about 5%. The transmission and reflection properties of the coated glasses were determined using an Hitachi U - 4000 spectrophotometer. The visible reflection and visible transmission of the coated glasses were determined using the D65 illuminant and the standard CIE 2°observer in accordance with the ISO 9050 standard (Parry Moon airmass 2) The haze of the coated glasses was measured using a WYK - Gardner Hazeguard+ haze meter. Photocatalytic activity for the purposes of this specification is determined by measuring the percentage reduction of the integrated absorption peaks corresponding to the C-H stretches of a thin film of stearic acid which is produced by illumination by UV light from a UVA lamp having an intensity of about 0.76 w/m²/nm at the surface of the substrate and a peak wavelength of 340nm for a period of 30 minutes.. The stearic acid film may be formed by spin casting a solution of stearic acid in methanol on the surface of the substrate.

The stearic acid film was formed on samples of the glasses, 7-8 cm square, by spin casting 20 µl of a solution of stearic acid in methanol (8.8 x 10⁻³ mol dm⁻³) on the coated surface of the glass at 2000 rpm for 1 minute. Infra red spectra were measured in transmission. The coated side of the glass was illuminated with a UVA-351 lamp (obtained from the Q-Panel Co., Cleveland, Ohio, USA) having a peak wavelength of 351 nm and an intensity at the surface of the coated glass of approximately 0.76 W / m².

The static water contact angle of the coated glasses was determined by measuring the diameter of a water droplet (volume in the range 1 to 5 µl) placed on the surface of the coated glass after irradiation of the coated glass using the UVA 351 lamp for about 2 hours (or as otherwise specified). In the preferred embodiments of this invention the contact angle is reduced to less than 10° and in the more preferred embodiments to less than 5°.

The invention is illustrated by the following examples.

A series of deposition processes were carried out utilising the equipment described in Figure 1.

### Examples 1 - 6

Six deposition processes were carried out the temperature of the glass at the point where the titanium precursor came into contact with it was 630°C. The line speed was 305 metres/hour. The parameters of the processes are presented as Table 1.

**TABLE ONE**

| Example | 1 | 2 | 3 | 4 | 5 | 6 |
|---|---|---|---|---|---|---|
| Substrate | S/C | F/G | S/C | F/G | S/C | S/C |
| Titanium Precursor | TIPO | TIPO | TIPO | TET | TET | TET |
| Ti Bubbler Temp °C | 160 | 160 | 160 | 158 | 174 | 174 |
| EtOAc Bubbler Temp °C | 60 | 60 | 60 | 60 | 60 | 60 |
| Ti Carrier Flow rate Litres/min | 0.8 | 1.4 | 1.4 | 0.4 | 0.8 | 0.8 |
| EtOAc Carrier flow rate Litres/min | 0.8 | 0.2 | 0.75 | 0.2 | 0.2 | 0.2 |
| Balance Flow Rate Litres/min | 35 | 35 | 35 | 35 | 35 | 35 |

| | | | | | | |
|---|---|---|---|---|---|---|
| S/C = Silica coated flow glass TIP0 = Titanium tetraisopropoxide F/G = Uncoated soda lime float glass TET = Titanium tetraethoxide | | | | | | |

### Examples 7 - 12

A second series of six deposition processes was carried out., The temperature of the glass at the point where the titanium precursor came into contact with it was 625°C. The line speed was 550 metre/hour. In certain of these examples a stream of oxygen gas was introduced and mixed with the precursor immediately prior to deposition on the glass. The parameters of the process are presented as Table 2.

**TABLE TWO**

| Example | 7 | 8 | 9 | 10 | 11 | 12 |
|---|---|---|---|---|---|---|
| Substrate | F/G | F/G | FIG | F/G | S/C | S/C |
| Titanium Precursor | TIPO | TIPO | TIPO | TET | TET | TET |
| Ti delivered cc/min | 26 | 26 | 26 | 11 | 11 | 11 |
| EtOAc Delivered cc/mm | 5 | 3 | 5 | 5 | 5 | 5 |
| Oxygen litres/min | 3 | 3 | 0 | 0 | 0 | 0 |
| Helium litres/min | 265 | 265 | 265 | 265 | 265 | 265 |
| Nitrogen litres/min | 290 | 290 | 290 | 290 | 290 | 290 |

The properties of the coated glasses produced in Example 1 to 12 were measured. Results are presented in Table 3.

**TABLE THREE**

| Property | TiO₂ Thickness nm | Reflection % | Haze % | Contact Angle | Photoactivity % removal after 30 minutes exposure | Humidity Test |
|---|---|---|---|---|---|---|
| 1 | 12 | 9.4 | 0.18 | 4.6 | 95 | Pass |
| 2 | 36 | 32.8 | 0.35 | 3.3 | 95 | Pass |
| 3 | 18.4 | 20.1 | 0.24 | 2.8 | 95 | Pass |
| 4 | - | 21.2 | 0.22 | 4.4 | 95 | Pass |
| 5 | 12 | 15.8 | 0.21 | 5.6 | 95 | Pass |
| 6 | 15 | 22.1 | 0.3 | 3.5 | 95 | Pass |
| 7 | 20 | 20.5 | 0.13 | 6.0 | 89 | Pass |
| 8 | 16 | 11.9 | 0.13 | 4.7 | 83 | Pass |
| 9 | 14 | 10.4 | 0.12 | 5.6 | 89 | Pass |
| 10 | 18 | 19.2 | 0.16 | 5.6 | 85 | Pass |
| 11 | 15 | 10.9 | 0.11 | 5.0 | 87 | Pass |
| 12 | 17 | 13.5 | 0.15 | 5.3 | 88 | Pass |

### Example 3

A third series of deposition processes were carried out using titanium tetra isopropoxide and ethyl acetate on a float glass ribbon having a thickness of 5.7mm. The line speed was 361 metres per hour. The deposition processes were carried out at one of two coating positions in the float bath. The temperature of the glass at these positions is shown in Table 4 below.

**TABLE FOUR**

| TiO₂ coater temp °C | Example | He/N₂ main flow slm | TTIP delivery cc/min | EtOAc delivery cc/min | Rf % | NaOH1 mol% @ 75°C |
|---|---|---|---|---|---|---|
| 700 | 13 | 600 | 15 | 0 | 15.5 | > 10 hrs |
| 700 | 14 | 600 | 15 | 4 | 14.4 | > 10 hrs |
| 700 | 15 | 600 | 15 | 8 | 14.0 | > 10 hrs |
| 700 | 16 | 600 | 15 | 12 | 11.6 | > 10 hrs |
| 625 | 17 | 600 | 11 | 8 | 15.8 | > 10 hrs |
| 625 | 18 | 600 | 11 | 0 | 21.2 | > 10 hrs |

Certain properties of the coated glasses produced in examples 17 and 18 were measured and are presented below in Table 5

**TABLE FIVE**

| Example No | 17 | 18 |
|---|---|---|
| T | 81.2 | 76.2 |
| a* | -2.2 | -2.0 |
| b* | 3.4 | 5.4 |
| R | 15.8 | 21.2 |
| a* | -0.1 | -0.4 |
| b* | -10.6 | -12.5 |
| Ra | 0.59 nm | 0.81 nm |
| Rms | 0.77 nm | 1.02 nm |
| Carbon Content | 7% | 15% |

Example 18 is a comparative example of a deposition process carried out in the absence of ethyl acetate.. Example 17 is an example of the invention carried out using ethyl acetate. The product of example 17 can be seen to be smoother and to have a more neutral colour.

### Example 4

A fourth series of deposition processes were carried out using titanium tetraethoxide and ethly acetate on a float ribbon having a thickness of 5.0mm. The line speed was 434 metres per hour. The deposition processes were carried out at one of the two coating positioned utilised in Example 3. The parameters of the processes are shown in Table 6

**TABLE SIX**

| TiO₂ coater temp °C | Example | He / N₂ main flow slm | TET delivery cc/min | EtOAc delivery cc/min | Rf % | NaOH 1 mol% @ 75°C |
|---|---|---|---|---|---|---|
| 700 | 19 | 600 | 10.5 | 0 | 16.6 | >10 hrs |
| 700 | 20 | 600 | 10.5 | 4.5 | 16.1 | >10 hrs |
| 700 | 21 | 600 | 10.5 | 7.9 | 16.2 | > 10 hrs |
| 700 | 22 | 600 | 10.5 | 11.3 | 16.0 | >10 hrs |
| 625 | 23 | 600 | 10.5 | 0 | 15.9 | >10 hrs |
| 625 | 24 | 600 | 10.5 | 4.5 | 15.4 | >10 hrs |
| 625 | 25 | 600 | 10.5 | 7.9 | 15.6 | >10 hrs |
| 625 | 26 | 600 | 10.5 | 11.3 | 15.6 | >10 hrs |

### Example 5

A fifth series of deposition processes was carried out using titanium tetra ethoxide and ethyl acetate on a float glass ribbon having a thickness of 3.2mm. The line speed was 558 metres per hour. The processes were carried out where the temperature of the glass was 625°C. The parameters of the process are shown in Table 7.

**TABLE SEVEN**

| TiO₂ coater temp °C | Example | He / N₂ main flow slm | TET delivery cc/min | EtOAc delivery cc/min | Rf % | NaOH 1 mol% @ 75°C |
|---|---|---|---|---|---|---|
| 625 | 27 | 600 | 11.75 | 5 | 15.5 | > 10 hrs |
| 625 | 28 | 600 | 11.75 | 6.6 | 14.8 | >10 hrs |
| 625 | 29 | 600 | 11.75 | 7.1 | 14.5 | >10 hrs |
| 625 | 30 | 600 | 11.75 | 8.8 | 14.2 | >10 hrs |

### Example 6

In this series of examples the deposition was carried out using a bi directional laboratory coater. In this coater a glass sheet is heated on a conveyor furnace to simulate the conditions encountered in a float glass production process. The glass was then passed to a reactor. A gaseous mixture comprising helium, the titanium precursor and ethyl acetate was brought into contact with the upper surface of the glass. The gaseous mixture was formed by mixing preheated gas streams as set out in Table 7.The higher temperature of the glass initiated the deposition of titanium oxide. The coated glass was removed and allowed to cool in air. The reflectivity and the durability of the coated glass was measured and is recorded in Table 8.

**TABLE EIGHT**

| Sample code | Conveyor speed ipm | He main flow slm | He upper flow slm | He/TTIP slm 160°C | He/EtOAc slm 60°C | Rf % | NaOH 1 mol% @ 75°C |
|---|---|---|---|---|---|---|---|
| 31 | 200 | 18 | 15 | 0.2 | 0.3 | 14.42 | > 10 hrs |
| 32 | 200 | 18 | 15 | 0.2 | 0.6 | 11.53 | >10 hrs |
| | | | | | | | |
| 33 | 200 | 18 | 15 | 0.2 | 0 | 13.91 | >10 hrs |
| 34 | 200 | 18 | 15 | 0.2 | 0.3 | 11.27 | > 10 hrs |
| 35 | 200 | 18 | 15 | 0.3 | 0 | 17.60 | >10 hrs |
| 36 | 200 | 18 | 15 | 0.3 | 0.3 | 14.63 | >10 hrs |
| | | | | | | | |
| 37 | 200 | 18 | 15 | 0.24 | 0.3 | 15.22 | >10 hrs |
| 38 | 200 | 18 | 15 | 0.24 | 0.15 | 18.29 | >10 hrs |

The results are presented as pairs of experiments which were performed on the same date. The laboratory apparatus generates the gas streams from a heated bubbler containing the reactant and the chemical delivery rate is sensitive to variations in the temperature of the bubbler. The setting of the bubbler temperature is not altered on any one day and the delivery rates are thereby comparable.

In each pair of experiments it can be seen that the introduction of ethyl acetate produced a coating which has a lower reflection whilst the durability of the coating was unaffected.

### Example 7

A further series of deposition processes were carried out in the float bath as described in Examples 1 to 5 above. The results are presented as Table 9

**TABLE NINE**

| TiO₂ coater temp °C | Example | He / N₂ main flow slm | TTIP delivery cc/min | EtOAc delivery cc/min | O₂ litres min | Rf% | NaOH 1 mol% @ 75°C |
|---|---|---|---|---|---|---|---|
| 700 | 39 | 600 | 15 | 4 | 0 | 14.4 | v. good |
| 700 | 40 | 600 | 15 | 4 | 0.5 | - | fail |
| 700 | 41 | 600 | 15 | 4 | 2.0 | 14.1 | fail |
| 700 | 42 | 600 | 15 | 12 | 0 | 11.6 | v. good |

Examples 40 and 41 introduce oxygen into the process of example 13 which is represented here as example 39. They illustrate that the introduction of oxygen may have a deleterious effect on the coating. Example 42 is an example of a thinner coating. This coating had a contact angle of 8.9°; it was unaffected by 7 hours in the sodium hydroxide durability test and it had a photoactivity of 90%

## Claims

1. A chemical vapour deposition process for the deposition of a photocatalytically active coating comprising titanium oxide on the surface of a glass ribbon produced during a float glass production process **characterised in that** the deposition takes place inside the float bath and **in that** the deposition process comprises contacting the surface with a vapour comprising titanium tetraethoxide or titanium tetraisopropoxide and a carboxylate ester at a temperature which is sufficiently high to form the titanium oxide coating.

2. A process according to claim 1 **characterised in that** the carboxylate ester is a compound having the general formula
R-C(O)-O-C(XX¹)-C(YY¹)-R¹
wherein R and R¹ which may be the same or different represent hydrogen atoms or an alkyl group comprising from 1 to 10 carbon atoms; X, X¹, Y and Y¹ which may be the same or different represent hydrogen atoms or alkyl groups comprising from 1 to 4 carbon atoms with the proviso that at least one of Y or Y¹ represents a hydrogen atom,

3. A process according to claim 2 **characterised in that** the carboxylate ester is an ester wherein R is an alkyl group comprising from 1 to 4 carbon atoms.

4. A process according to claim 3 **characterised in that** the alkyl group is an ethyl group.

5. A process according to claim 2 **characterised in that** the carboxylate ester is selected from the group comprising ethyl formate, ethyl acetate, ethyl propionate, ethyl butyrate, n-propyl formate, n-propyl acetate, n-propyl propionate, n propyl butyrate, isopropyl formate, isopropyl acetate, isopropyl propionate, isopropyl butyrate, n-butyl formate, n-butyl acetate, sec butyl acetate and t butyl acetate

6. A process according to claim 5 **characterised in that** the carboxylate ester is ethyl acetate

7. A process according to any of the preceding claims **characterised in that** the substrate is at a temperature in the range 400°C to 800°C.

8. A process according to any of the preceding claims **characterised in that** the substrate is at a temperature of from 610°C to 720°C.

## Patentansprüche

1. Verfahren der chemischen Gasphasenabscheidung für die Abscheidung einer photokatalytisch wirksamen Beschichtung, die Titanoxid umfasst, auf der Oberfläche eines in einem Floatglasverfahren hergestellten Glasbandes, **dadurch gekennzeichnet, dass** die Abscheidung innerhalb des Floatbades erfolgt, und **dadurch**, dass der Abscheidungsprozess umfasst, die Oberfläche bei einer Temperatur, die ausreichend hoch ist, die Titanoxidbeschichtung zu bilden, mit einem Dampf in Kontakt zu bringen, der Titantetraethoxid oder Titantetrapropoxid und einen Carbonsäureester enthält.

2. Verfahren nach Anspruch 1, **dadurch gekennzeichnet, dass** es sich bei dem Carbonsäureester um eine Verbindung der folgenden allgemeinen Formel handelt:
R-C(O)-O-C(XX¹)-C(YY¹)-R¹
wobei R und R¹, die gleich oder verschieden sein können, Wasserstoffatome oder eine Alkylgruppe mit 1 bis 10 Kohlenstoffatomen bedeuten; und X, X¹, Y und Y¹, die gleich oder verschieden sein können, Wasserstoffatome oder Alkylgruppen mit 1 bis 4 Kohlenstoffatomen bedeuten, mit der Maßgabe, dass zumindest eine Gruppe Y oder Y¹ ein Wasserstoffatom bedeutet.

3. Verfahren nach Anspruch 2, **dadurch gekennzeichnet, dass** der Carbonsäureester ein Ester ist, bei dem R eine Alkylgruppe mit 1 bis 4 Kohlenstoffatomen bedeutet.

4. Verfahren nach Anspruch 3, **dadurch gekennzeichnet, dass** die Alkylgruppe eine Ethylgruppe ist.

5. Verfahren nach Anspruch 2, **dadurch gekennzeichnet, dass** der Carbonsäureester unter Ethylformiat, Ethylacetat, Ethylpropionat, Ethylbutyrat, *n*-Propylformiat, *n*-Propylacetat, *n*-Propylpropionat, *n*-Propylbutyrat, Isopropylformiat, Isopropylacetat, Isopropylpropionat, Isopropylbutyrat, *n*-Butylformiat, *n*-Butylacetat, *sec*-Butylacetat und *tert-*Butylacetat ausgewählt ist.

6. Verfahren nach Anspruch 5, **dadurch gekennzeichnet, dass** es sich bei dem Carbonsäureester um das Ethylacetat handelt.

7. Verfahren nach einem der vorhergehenden Ansprüche, **dadurch gekennzeichnet, dass** das Substrat eine Temperatur im Bereich von 400 bis 800 °C aufweist.

8. Verfahren nach einem der vorhergehenden Ansprüche, **dadurch gekennzeichnet, dass** das Substrat eine Temperatur im Bereich von 610 bis 720 °C aufweist.

## Revendications

1. Procédé de dépôt chimique en phase vapeur pour le dépôt d'un revêtement photocatalytiquement actif comprenant de l'oxyde de titane sur la surface d'un ruban de verre produit au cours d'un procédé de production de verre flotté, **caractérisé en ce que** le dépôt s'effectue à l'intérieur du bain de flottement et **en ce que** le procédé de dépôt comprend la mise en contact de la surface avec une vapeur comprenant du tétraéthylate de titane ou du tétraisopropylate de titane et un ester carboxylate à une température qui est suffisamment élevée pour la formation du revêtement d'oxyde de titane.

2. Procédé suivant la revendication 1, **caractérisé en que** l'ester carboxylate est un composé répondant à la formule générale
R-C(O)-O-C(XX¹)-C(YY¹)-R¹
dans laquelle R et R¹, qui peuvent être identiques ou différents, représentent des atomes d'hydrogène ou un groupe alkyle comprenant 1 à 10 atomes de carbone ; X, X¹, Y et Y¹, qui peuvent être identiques ou différents, représentent des atomes d'hydrogène ou des groupes alkyle comprenant 1 à 4 atomes de carbone, sous réserve qu'au moins un de Y et Y¹ représente un atome d'hydrogène.

3. Procédé suivant la revendication 2, **caractérisé en que** l'ester carboxylate est un ester dans lequel R représente un groupe alkyle comprenant 1 à 4 atomes de carbone.

4. Procédé suivant la revendication 3, **caractérisé en que** le groupe alkyle est un groupe éthyle.

5. Procédé suivant la revendication 2, **caractérisé en que** l'ester carboxylate est choisi dans le groupe comprenant le formiate d'éthyle, l'acétate d'éthyle, le propionate d'éthyle, le butyrate d'éthyle, le formiate de n-propyle, l'acétate de n-propyle, le propionate de n-propyle, le butyrate de n-propyle, le formiate d'isopropyle, l'acétate d'isopropyle, le propionate d'isopropyle, le butyrate d'isopropyle, le formiate de n-butyle, l'acétate de n-butyle, l'acétate de sec.-butyle et l'acétate de tertiobutyle.

6. Procédé suivant la revendication 5, **caractérisé en ce que** l'ester carboxylate est l'acétate d'éthyle.

7. Procédé suivant l'une quelconque des revendications précédentes, **caractérisé en ce que** le substrat est à une température comprise dans l'intervalle de 400°C à 800°C.

8. Procédé suivant l'une quelconque des revendications précédentes, **caractérisé en ce que** le substrat est à une température comprise dans l'intervalle de 610°C à 720°C.
